# FASCICULE DE BREVET EUROPEEN

(11) **EP 2 599 125 B1**
(45) Date de publication et mention de la délivrance du brevet: **11.09.2019**
(21) Numéro de dépôt: 11741671.9
(22) Date de dépôt: 13.07.2011
(51) Int. Cl.: H01L 29/812, H01L 29/808, H01L 29/78, H01L 29/10, H01L 29/872, H01L 29/06, H01L 29/16

(54) **STRUCTURE SEMI-CONDUCTRICE POUR INTERRUPTEUR ÉLECTRONIQUE DE PUISSANCE**
HALBLEITERSTRUKTUR FÜR EINEN ELEKTRONISCHEN LEISTUNGSSCHALTER
SEMICONDUCTOR STRUCTURE FOR AN ELECTRONIC POWER SWITCH

(30) Priorité: 29.07.2010 FR 1056285
(43) Date de publication de la demande: 05.06.2013
(73) Titulaire: Institut National des Sciences Appliquées de Lyon, 69621 Villeurbanne (FR); Centre National de la Recherche Scientifique, 75794 Paris Cedex 16 (FR)
(72) Inventeur: TOURNIER, Dominique, F-69009 Lyon (FR); BROSSELARD, Pierre, F-69100 Villeurbanne (FR); CHEVALIER, Florian, F-42000 Saint Etienne (FR)
(74) Mandataire: Be IP
(86) Numéro de dépôt international: PCT/FR2011/051683
(87) Numéro de publication internationale: WO 2012/013888

(56) Documents cités:
- DE-A1- 19 900 169
- US-A1- 2005 184 317

## Description

La présente invention se rapporte à une structure semi-conductrice pour interrupteur électronique de puissance ainsi qu'à un interrupteur électronique de puissance comportant une pluralité de telles structures semi-conductrices.

Une structure semi-conductrice pour interrupteur électronique de puissance connue de l'état de la technique, notamment du document US 6,459,108, comporte :
- un substrat d'un premier type de conductivité, présentant une face inférieure et une face supérieure,
- une électrode de drain en contact avec la face inférieure du substrat,
- une première région semi-conductrice, du premier type de conductivité, présentant une surface inférieure agencée sur la face supérieure du substrat, et une surface supérieure munie d'une zone de contact,
- une électrode de source en contact avec la zone de contact de la première région semi-conductrice,
- une deuxième région semi-conductrice, d'un second type de conductivité, agencée à l'intérieur de la première région semi-conductrice, sous la zone de contact, de manière à délimiter un premier canal de conduction vertical du premier type de conductivité et un second canal de conduction latéral du premier type de conductivité entre l'électrode de drain et l'électrode de source, la première et la deuxième région semi-conductrice formant une première jonction de type p-n,
- une troisième région semi-conductrice, du second type de conductivité, agencée sur la surface supérieure de la première région semi-conductrice et à distance de la zone de contact, la première et la troisième région semi-conductrice formant une seconde jonction de type p-n,
- une électrode de grille en contact avec la troisième région semi-conductrice.

Une telle structure semi-conductrice de l'état de la technique est une structure d'un transistor de type JFET (Acronyme anglais pour *Junction Field Effect Transistor*) permettant d'obtenir un interrupteur électronique de puissance. Par la suite, par souci de simplicité, les termes « drain », « source » et « grille » pourront se substituer respectivement aux expressions électrode de drain, électrode de source et électrode de grille.

Lorsque la tension de polarisation entre le drain et la source, notée VDs, est négative, en particulier inférieure ou égale à -3 V, la diode formée par la source, la grille et la seconde jonction p-n fournit un courant bipolaire parasite altérant les performances électriques de la structure semi-conductrice. A cet égard, de par la présence de la seconde jonction p-n, le courant circulant entre le drain et la source, noté IDS, est fortement limité tandis que le courant circulant entre la grille et la source, noté IGS, est suffisamment élevé pour pouvoir endommager la structure semi-conductrice.

Le document US 2005/184317 décrit une structure semi-conductrice comprenant un substrat d'un premier type de conductivité n+, une électrode de drain, une première région semi-conductrice d'un type de conductivité n- présentant une surface inférieure en contact avec la surface supérieure du substrat, une électrode de source, une électrode de grille et une deuxième région semi-conductrice d'un second type de conductivité p+.

Le document DE 199 00 169 décrit une structure semi-conductrice comprenant un substrat n+, une électrode de drain en contact avec la face inférieure du substrat, une première région semi-conductrice d'un premier type de conductivité, présentant une surface inférieure agencée sur la face supérieure du substrat, et une surface supérieure munie d'une zone de contact, une électrode de source en contact avec la zone de contact de la première région semi-conductrice, une deuxième région semi-conductrice d'un second type de conductivité, agencée à l'intérieur de la première région semi-conductrice, sous la zone de contact, de manière à délimiter une premier et un second canal de conduction du premier type de conductivité entre l'électrode de drain et l'électrode de source, et une électrode de grille métallique en contact avec la surface supérieure de la première région semi-conductrice de manière à former une jonction de type Schottky, l'électrode de grille étant agencée à distance de la zone de contact.

La présente invention vise à remédier en tout ou partie aux inconvénients précités et concerne une structure semi-conductrice telle que définie à la revendication 1.

Ainsi, une telle structure semi-conductrice selon l'invention permet de s'affranchir d'une seconde jonction de type p-n et par là-même d'une diode fournissant un courant bipolaire parasite lorsque VDs est négative.

La première grille, la source et la première jonction de type Schottky forment une première diode de type Schottky fournissant un courant unipolaire de porteurs majoritaires permettant, lorsque VDs est négative, de réduire IGS (courant circulant entre la première grille et la source) afin de protéger au mieux la première grille et la structure semi-conductrice.

De même, la seconde grille, la source et la seconde jonction de type Schottky forment une seconde diode de type Schottky fournissant un courant unipolaire de porteurs majoritaires permettant, lorsque VDs est négative, de réduire IGS (courant circulant entre la seconde grille et la source) afin de protéger au mieux la seconde grille et la structure semi-conductrice.

Les première et seconde diodes de type Schottky précitées permettent par ailleurs d'augmenter IDs afin d'améliorer les performances de la structure semi-conductrice en termes de conduction électrique.

Par ailleurs, une telle structure semi-conductrice comporte deux grilles, au lieu d'une seule, pour commander l'interrupteur de puissance, ce qui permet d'envisager une augmentation de la vitesse de commutation de l'interrupteur. Cette augmentation de la vitesse de commutation est possible grâce à la diminution de la charge stockée dans une telle structure de par la conduction unipolaire.

Dans un mode de réalisation, la deuxième région semi-conductrice comporte au moins un caisson, du second type de conductivité, agencé sous la deuxième portion de la première électrode de grille de manière à délimiter une première jonction de type Schottky de part et d'autre du ou de chaque caisson.

Ainsi, le ou les caissons et les premières jonctions de type Schottky sont interdigités de manière à former avec la première grille et la source une diode de type JBS (acronyme anglais pour Junction Barrier Schottky). Une telle diode JBS permet de réduire IGS (courant circulant entre la première électrode de grille et l'électrode de source) et d'augmenter IDs relativement à une diode p-n de l'état de la technique formée par la source, la grille et la seconde jonction p-n.

Avantageusement, chaque caisson présente un niveau de dopage du second type de conductivité adapté pour former un contact ohmique avec la première électrode de grille.

Ainsi, de tels contacts ohmiques formés permettent de réduire le champ électrique s'appliquant à chaque première jonction de type Schottky afin de réduire les risques de dégradation rapide de chaque première jonction de type Schottky.

Dans un mode de réalisation, la face supérieure de la première région semi-conductrice comporte au moins un caisson, du second type de conductivité, agencé sous la première portion de la seconde électrode de grille de manière à délimiter une seconde jonction de type Schottky de part et d'autre du ou de chaque caisson.

Ainsi, le ou les caissons et les secondes jonctions de type Schottky sont interdigités de manière à former avec la seconde grille et la source une diode de type JBS. Une telle diode JBS permet de réduire I_{GS} (courant circulant entre la seconde électrode de grille et l'électrode de source) et d'augmenter I_{DS} relativement à une diode p-n de l'état de la technique formée par la source, la grille et la seconde jonction p-n.

Avantageusement, chaque caisson présente un niveau de dopage du second type de conductivité adapté pour former un contact ohmique avec la seconde électrode de grille.

Ainsi, de tels contacts ohmiques formés permettent de réduire le champ électrique s'appliquant à chaque seconde jonction de type Schottky afin de réduire les risques de dégradation rapide de chaque seconde jonction de type Schottky.

Dans un mode de réalisation, la structure semi-conductrice comporte une couche diélectrique, de préférence réalisée en silice, agencée sur la face supérieure de la première région semi-conductrice, et la seconde électrode de grille présente au moins une deuxième portion surmontant la couche diélectrique.

Ainsi, la présence d'une telle couche diélectrique permet de réduire les courants de fuite à travers la ou chaque deuxième portion de la seconde grille.

Avantageusement, la zone de contact présente un niveau de dopage du premier type de conductivité adapté pour former un contact ohmique avec l'électrode de source.

Avantageusement, le substrat présente un niveau de dopage du premier type de conductivité adapté pour former un contact ohmique avec l'électrode de drain.

Avantageusement, la deuxième région semi-conductrice présente un niveau de dopage du second type de conductivité adapté pour former un contact ohmique avec la première électrode de grille.

Dans un mode de réalisation, la structure semi-conductrice comporte au moins une couche de protection du second type de conductivité agencée en périphérie d'une jonction entre la première et la seconde région semi-conductrice, la couche de protection présentant un niveau de dopage adapté pour optimiser la tenue en tension de la structure semi-conductrice.

Ainsi, la présence d'une telle couche permet d'obtenir une protection périphérique de type JTE (acronyme anglais pour *Junction Termination Extension*) d'une jonction entre la première et la seconde région semi-conductrice.

Avantageusement, le substrat, la première et la deuxième région semi-conductrice sont réalisés dans un matériau sélectionné dans le groupe comportant le carbure de silicium, le nitrure de gallium et le diamant, et de préférence le carbure de silicium.

Ainsi, une telle structure semi-conductrice peut être intégrée de manière monolithique.

En outre, comme la structure semi-conductrice doit supporter des tensions de fonctionnement notamment supérieures à 1000 V, les matériaux du groupe doivent avoir une bande interdite large, c'est-à-dire une largeur de bande interdite supérieure à 1,7 eV.

La présente invention se rapporte également à un interrupteur électronique de puissance comportant une pluralité de structures semi-conductrices conformes à l'invention.

Dans un mode de réalisation, la pluralité de structures semi-conductrices est agencée de manière à délimiter au moins un premier motif hexagonal sensiblement régulier et/ou au moins un deuxième motif en bandes interdigitées.

Avantageusement, l'interrupteur électronique de puissance comporte une cellule de protection de la première électrode de grille agencée sensiblement au centre de chaque premier motif et/ou agencée entre deux bandes interdigitées de chaque deuxième motif.

Ainsi, une telle disposition des cellules de protection permet d'uniformiser la protection de la première grille pour un composant de grande taille formant un interrupteur électronique de puissance.

D'autres caractéristiques et avantages apparaîtront dans la description qui va suivre de trois modes de réalisation d'une structure semi-conductrice pour interrupteur électronique de puissance selon l'invention, donné à titre d'exemples non limitatifs, en référence aux dessins annexés dans lesquels :
- la figure 1 est une vue schématique en coupe transversale d'une structure semi-conductrice selon un premier mode de réalisation,
- la figure 2 est une vue schématique en coupe transversale d'une structure semi-conductrice selon un deuxième mode de réalisation,
- la figure 3 est une vue schématique en coupe transversale d'une structure semi-conductrice selon un troisième mode de réalisation,
- la figure 4 est un graphique représentant I_{DS}, en densité surfacique, en fonction de V_{DS} pour une structure semi-conductrice selon l'invention (courbe C) et pour une structure semi-conductrice de l'état de la technique (courbe D),
- la figure 5 est un graphique représentant I_{GS}, en densité surfacique, en fonction de V_{DS} pour une structure semi-conductrice selon l'invention (courbe A) et pour une structure semi-conductrice de l'état de la technique (courbe B),
- la figure 6 est une vue schématique partielle de dessus d'un interrupteur électronique de puissance selon une première forme d'exécution,
- la figure 7 est une vue schématique partielle de dessus d'un interrupteur électronique de puissance selon une deuxième forme d'exécution.

Pour les différents modes de réalisation, les mêmes références seront utilisées pour des éléments identiques ou assurant la même fonction, par souci de simplification de la description.

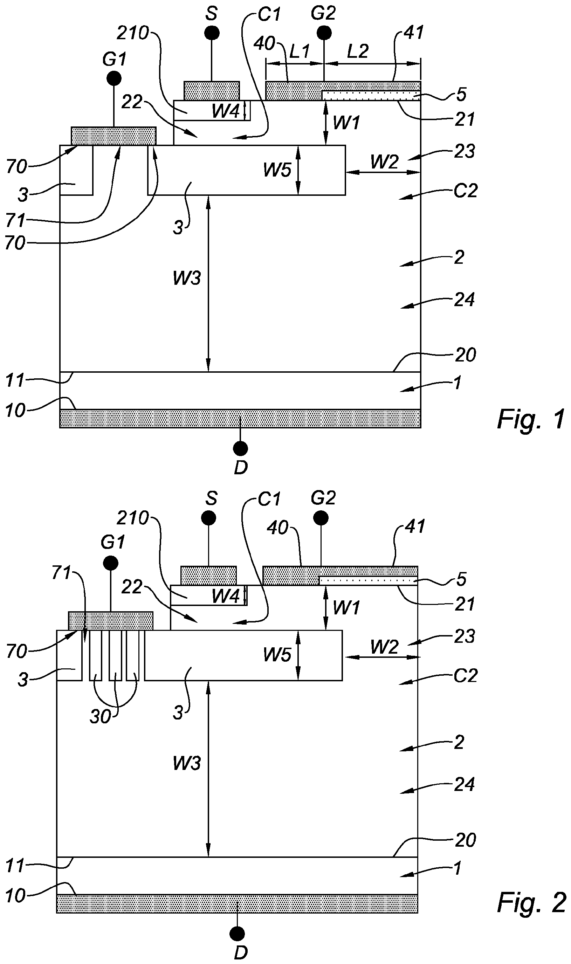

La structure semi-conductrice illustrée à la figure 1 comporte :
- un substrat 1 de conductivité de type n (c'est-à-dire conducteur d'électrons), présentant une face inférieure 10 et une face supérieure 11,
- une électrode de drain D en contact avec la face inférieure 10 du substrat 1,
- une première région semi-conductrice 2, de conductivité de type n, présentant une surface inférieure 20 agencée sur la face supérieure 11 du substrat 1, et une surface supérieure 21 munie d'une zone de contact 210,
- une électrode de source S en contact avec la zone de contact 210 de la première région semi-conductrice 2,
- une deuxième région semi-conductrice 3, de conductivité de type p (c'est-à-dire conducteur de trous), agencée à l'intérieur de la première région semi-conductrice 2, sous la zone de contact 210, de manière à délimiter un premier canal de conduction C1 latéral et un second canal de conduction C2 vertical entre l'électrode de drain D et l'électrode de source S. Les premier et second canaux de conduction C1, C2 sont de conductivité de type n,
- une première électrode de grille G1 métallique présentant des premières portions 70 en contact avec la deuxième région semi-conductrice 3 et une deuxième portion 71 en contact avec la première région semi-conductrice 2 de manière à former une première jonction de type Schottky,
- une seconde électrode de grille G2 métallique présentant une première portion 40 en contact avec la surface supérieure 21 de la première région semi-conductrice 2 de manière à former une seconde jonction de type Schottky, la seconde électrode de grille G2 étant agencée à distance de la zone de contact 210.

Le substrat 1, par exemple de type wafer, présente un niveau de dopage de type n adapté pour former un contact ohmique avec l'électrode de drain D. A cet égard, le substrat 1 présente une résistivité de préférence comprise entre 0.015 et 0.03 ohm.cm.

La première région semi-conductrice 2 présente une première zone semi-conductrice 22 de conductivité de type n agencée au-dessus de la deuxième région semi-conductrice 3. La première zone semi-conductrice 22 définit la hauteur W1 du premier canal de conduction C1. La hauteur W1 du premier canal de conduction C1 est de l'ordre de 3 µm.

La première région semi-conductrice 2 présente une deuxième zone semi-conductrice 23 de conductivité de type n agencée latéralement à la deuxième région semi-conductrice 3. La deuxième zone semi-conductrice 23 définit la largeur W2 du second canal de conduction C2. La largeur W2 du second canal de conduction C2 est de l'ordre de 3 µm.

La première région semi-conductrice 2 présente une troisième zone semi-conductrice 24 de conductivité de type n agencée au-dessous de la deuxième région semi-conductrice 3. L'épaisseur W3 de la troisième zone semi-conductrice 24 est de l'ordre de 40 µm. La troisième zone semi-conductrice 24 présente un niveau de dopage de type n de l'ordre de 10¹⁵ at.cm⁻³ très inférieur au niveau de dopage de type n de la première et de la deuxième zone semi-conductrice 22, 23. En effet, le niveau de dopage de type n de la première et de la deuxième zone semi-conductrice 22, 23 est de l'ordre de 10¹⁶ at.cm⁻³.

La zone de contact 210, de conductivité de type n, est ménagée à la surface supérieure 21 de la première région semi-conductrice 2. La zone de contact 210 présente un niveau de dopage de type n adapté pour former un contact ohmique avec l'électrode de source S. A cet effet, la zone de contact 210 présente un niveau de dopage de type n de l'ordre de 10¹⁹ at.cm⁻³ très supérieur au niveau de dopage de type n de la première et de la deuxième zone semi-conductrice 23, 24. L'épaisseur W4 de la zone de contact 210 est de l'ordre de 0,2 µm.

La deuxième région semi-conductrice 3 présente un niveau de dopage de type p adapté pour former un contact ohmique avec la première électrode de grille G1. A cet effet, la deuxième région semi-conductrice 3 présente un niveau de dopage de type p de l'ordre de 10¹⁹ at.cm⁻³. L'épaisseur W5 de la deuxième région semi-conductrice 3 est de l'ordre de 0,5 µm.

La structure semi-conductrice comporte en outre une couche diélectrique 5, pouvant être réalisée en silice, agencée sur la face supérieure 21 de la première région semi-conductrice 2. L'épaisseur de la couche diélectrique 5 est de l'ordre de 40 nm.

La seconde électrode de grille G2 présente une deuxième portion 41 surmontant la couche diélectrique 5. La deuxième portion 41 de la seconde électrode de grille G2 présente une largeur L2 de l'ordre de 5 µm. La première portion 40 de la seconde électrode de grille G2 présente une largeur L1 de l'ordre de 5 µm.

La deuxième portion 71 de la première électrode de grille G1 en contact avec la première région semi-conductrice 2 forme une première jonction de type Schottky, c'est-à-dire une jonction métal/semi-conducteur de type n.

La première portion 40 de la seconde électrode de grille G2 en contact avec la surface supérieure 21 de la première région semi-conductrice 2 forme une seconde jonction de type Schottky, c'est-à-dire une jonction métal/semi-conducteur de type n.

La première électrode de grille G1, l'électrode de source S et la première jonction de type Schottky forment une première diode de type Schottky fournissant un courant unipolaire de porteurs majoritaires (électrons).

De même, la seconde électrode de grille G2, l'électrode de source S et la seconde jonction de type Schottky forment une seconde diode de type Schottky fournissant un courant unipolaire de porteurs majoritaires (électrons).

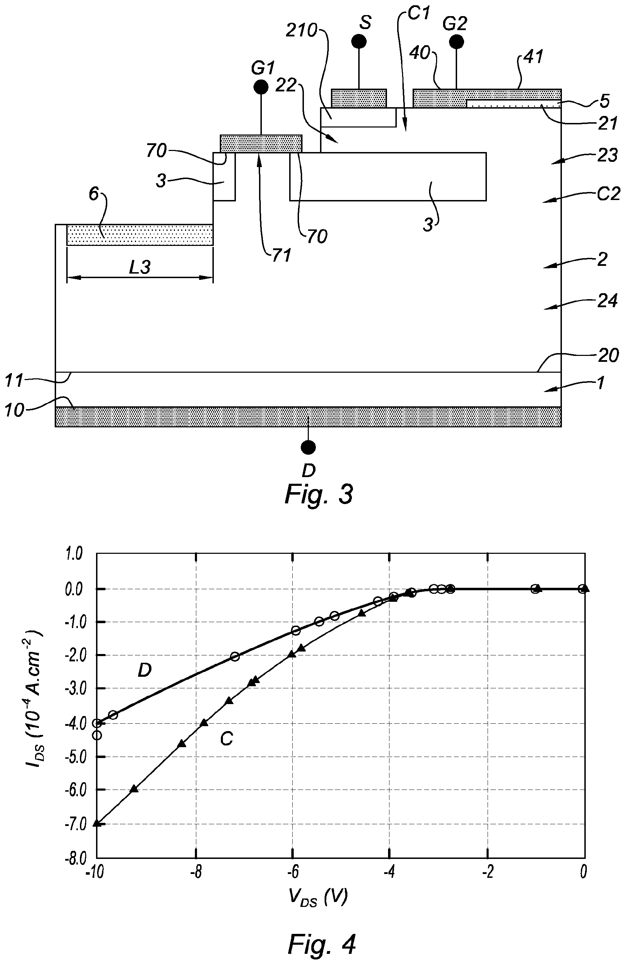

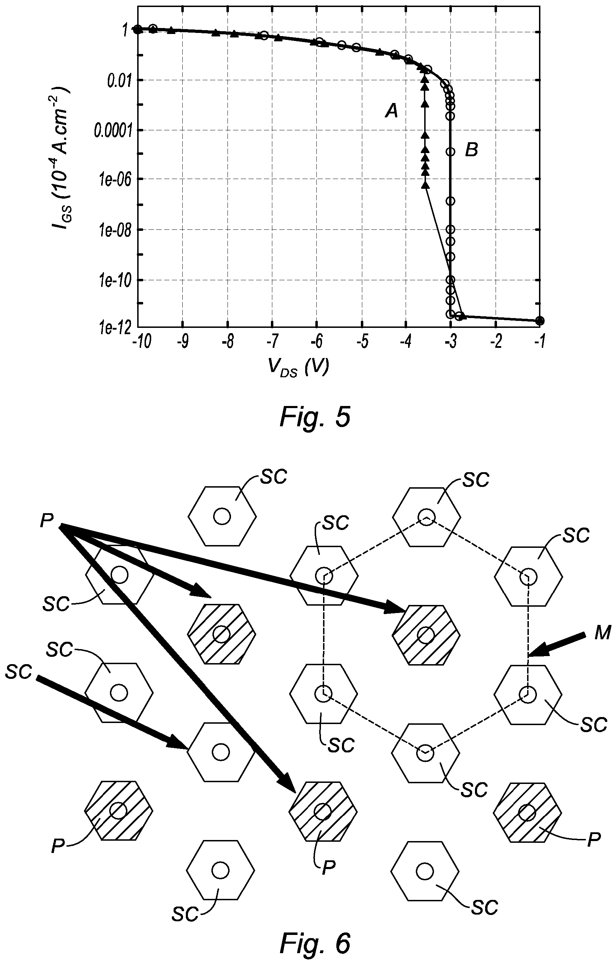

Comme illustré aux figures 4 et 5, lorsque la tension de polarisation entre l'électrode de drain D et l'électrode de source S, noté V_{DS}, est négative, Chaque diode de type Schottky précitée permet, relativement à une diode de type p-n de l'état de la technique, de :
- réduire le courant, en valeur absolue, circulant entre l'électrode de grille correspondante et l'électrode de source S, noté I_{GS}, (voir la courbe A relativement à la courbe B de la figure 5) afin de protéger au mieux l'électrode grille correspondante et la structure semi-conductrice, et
- augmenter le courant, en valeur absolue, circulant entre l'électrode de drain D et l'électrode de source S, noté I_{DS}, (voir la courbe C relativement à la courbe D de la figure 4) afin d'améliorer les performances de la structure semi-conductrice en terme de conduction électrique.

En outre, la première diode de type Schottky permet d'augmenter la tension d'amorçage de la seconde électrode de grille G2, en valeur absolue, c'est-à-dire la tension de mise en conduction de la seconde électrode de grille G2 (voir la courbe A relativement à la courbe B de la figure 5). A la figure 5, à titre d'exemple, la tension d'amorçage est passée de -2.8 V à -3.6 V.

Le substrat 1, la première et la deuxième région semi-conductrice 2, 3 sont réalisés en carbure de silicium. Le substrat 1, la première et la deuxième région semi-conductrice 2, 3 peuvent également être réalisés en nitrure de gallium ou en diamant.

Un procédé de fabrication d'une telle structure semi-conductrice comporte les étapes consistant à :
a) fournir le substrat 1,
b) faire croître la troisième zone semi-conductrice 24 de la première région semi-conductrice 2 sur la face supérieure 11 du substrat 1, de préférence par épitaxie,
c) faire croître la deuxième zone semi-conductrice 23 de la première région semi-conductrice 2 sur la troisième zone semi-conductrice 24, de préférence par épitaxie,
d) implanter, de préférence par implantation ionique, la deuxième région semi-conductrice 3 à l'intérieur de la deuxième zone semi-conductrice 23,
e) faire croître la première zone semi-conductrice 22 de la première région semi-conductrice 2 sur la deuxième zone semi-conductrice 23, de préférence par épitaxie,
f) implanter, de préférence par implantation ionique, la zone de contact 210 à l'intérieur de la première zone semi-conductrice 22,
g) graver la partie supérieure de la première zone semi-conductrice 22 jusqu'à atteindre la deuxième région semi-conductrice 3,
h) déposer la couche diélectrique 5 sur la première zone semi-conductrice 22,
i) déposer une couche de métallisation sur la face inférieure 10 du substrat 1 de manière à former l'électrode de drain D,
j) déposer une couche de métallisation sur la deuxième région semi-conductrice 3 de manière à former la première électrode de grille G1,
k) déposer une couche de métallisation sur la zone de contact 210 de manière à former l'électrode de source S,
l) déposer une couche de métallisation sur la première zone semi-conductrice 22 et sur la couche diélectrique 5 de manière à former respectivement la première et la deuxième portion 40, 41 de la seconde électrode de grille G2.

Selon un mode de réalisation illustré à la figure 2, la structure semi-conductrice diffère de la structure semi-conductrice illustrée à la figure 1 en ce que la deuxième région semi-conductrice 3 comporte une pluralité de caissons 30, de conductivité de type p, agencée sous la deuxième portion 71 de la première électrode de grille G1 de manière à délimiter une première jonction de type Schottky de part et d'autre de chaque caisson 30. Ainsi, une telle pluralité de caissons 30 délimite une pluralité de premières jonctions de type Schottky. Les caissons 30 et les premières jonctions de type Schottky sont interdigités de manière à former avec la première électrode de grille G1 et l'électrode de source S une diode de type JBS. Une telle diode JBS permet de réduire I_{GS} et d'augmenter I_{DS} relativement à une diode de type p-n de l'état de la technique. En outre, l'espacement entre les caissons 30 détermine la tension d'amorçage de la seconde électrode de grille G2.

Chaque caisson 30 présente un niveau de dopage de type p adapté pour former un contact ohmique avec la première électrode de grille G1. A cet effet, chaque caisson 30 présente un niveau de dopage de type p compris de préférence entre 10¹⁹ at.cm⁻³ et 4*10¹⁹ at.cm⁻³.

Selon un mode de réalisation illustré à la figure 3, la structure semi-conductrice diffère de la structure semi-conductrice illustrée à la figure 1 en ce qu'elle comporte une couche de protection 6 de conductivité de type p.

La couche de protection 6 est agencée en périphérie de la jonction de type p-n entre la troisième zone semi-conductrice 24 de la première région semi-conductrice 2 et la seconde région semi-conductrice 3. La longueur L3 de la couche de protection 6 est de l'ordre de 120 µm. La couche de protection 6 présente un niveau de dopage de type p adapté pour optimiser la tenue en tension de la structure semi-conductrice. Pour ce faire, la dose de dopants de type p est de l'ordre de 10¹³ at.cm⁻².

L'interrupteur électronique de puissance schématisé à la figure 6 comporte :
- une pluralité de structures semi-conductrices SC conformes à l'invention agencée de manière à délimiter des premiers motifs M hexagonaux sensiblement réguliers de type nid d'abeille,
- une cellule de protection P de la première électrode de grille G1 (non représentée) agencée sensiblement au centre de chaque premier motif M.

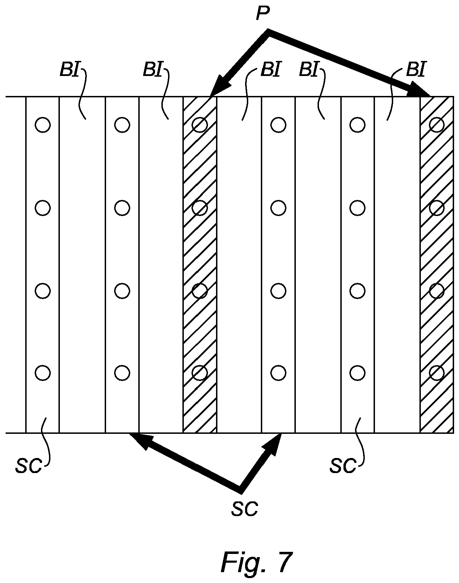

L'interrupteur électronique de puissance schématisé à la figure 7 diffère de l'interrupteur électronique de puissance schématisé à la figure 6 en ce que :
- la pluralité de structures semi-conductrices SC est agencée de manière à délimiter des deuxièmes motifs en bandes interdigitées BI,
- une cellule de protection P est agencée entre deux bandes interdigitées BI de chaque deuxième motif.

Bien entendu, les modes de réalisation de l'invention décrits ci-dessus ne présentent aucun caractère limitatif. Des détails et améliorations peuvent y être apportés dans d'autres variantes d'exécution sans pour autant sortir du cadre de l'invention.

## Revendications

1. Structure semi-conductrice pour interrupteur électronique de puissance, comportant :
- un substrat (1) d'un premier type de conductivité, présentant une face inférieure (10) et une face supérieure (11),
- une électrode de drain (D) en contact avec la face inférieure (10) du substrat (1),
- une première région semi-conductrice (2), du premier type de conductivité, présentant une surface inférieure (20) agencée sur la face supérieure (11) du substrat (1), et une surface supérieure (21) munie d'une zone de contact (210),
- une électrode de source (S) en contact avec la zone de contact (210) de la première région semi-conductrice (2),
- une deuxième région semi-conductrice (3), d'un second type de conductivité, agencée à l'intérieur de la première région semi-conductrice (2), sous la zone de contact (210), de manière à délimiter un premier et un second canal de conduction (C1 , C2) du premier type de conductivité entre l'électrode de drain (D) et l'électrode de source (S), le second canal de conduction (C2) s'étendant suivant une seconde direction sensiblement verticale et le premier canal de conduction (C1) s'étendant suivant une première direction sensiblement perpendiculaire à la seconde direction,
la structure semi-conductrice comportant en outre:
- une première électrode de grille (G1) métallique indépendante de l'électrode de source et présentant au moins une première portion (70) en contact avec la deuxième région semi-conductrice (3), et au moins une deuxième portion (71) en contact avec la première région semi-conductrice (2) de manière à former une première jonction de type Schottky, la première jonction étant entourée de la deuxième région semi-conductrice, et
- une seconde électrode de grille (G2) métallique indépendante de l'électrode de source et présentant au moins une première portion (40) en contact avec la surface supérieure (21) de la première région semi-conductrice (2) de manière à former une seconde jonction de type Schottky, la seconde électrode de grille (G2) étant agencée à distance de la zone de contact (210).

2. Structure semi-conductrice selon la revendication 1, **caractérisée en ce que** la deuxième région semi-conductrice (3) comporte au moins un caisson (30), du second type de conductivité, agencé sous la deuxième portion (71) de la première électrode de grille (G1) de manière à délimiter une première jonction de type Schottky de part et d'autre du ou de chaque caisson (30).

3. Structure semi-conductrice selon la revendication 2, **caractérisée en ce que** chaque caisson (30) présente un niveau de dopage du second type de conductivité adapté pour former un contact ohmique avec la première électrode de grille (G1).

4. Structure semi-conductrice selon l'une des revendications 1 à 3, **caractérisée en ce que** la face supérieure (21) de la première région semi-conductrice (2) comporte au moins un caisson, du second type de conductivité, agencé sous la première portion (40) de la seconde électrode de grille (G2) de manière à délimiter une seconde jonction de type Schottky de part et d'autre du ou de chaque caisson.

5. Structure semi-conductrice selon la revendication 4, **caractérisée en ce que** chaque caisson présente un niveau de dopage du second type de conductivité adapté pour former un contact ohmique avec la seconde électrode de grille (G2).

6. Structure semi-conductrice selon l'une des revendications 1 à 5, **caractérisée en ce qu'**elle comporte une couche diélectrique (5), de préférence réalisée en silice, agencée sur la face supérieure (21) de la première région semi-conductrice (2), et **en ce que** la seconde électrode de grille (G2) présente au moins une deuxième portion (41) surmontant la couche diélectrique (5).

7. Structure semi-conductrice selon l'une des revendications 1 à 6, **caractérisée en ce que** la zone de contact (210) présente un niveau de dopage du premier type de conductivité adapté pour former un contact ohmique avec l'électrode de source (S).

8. Structure semi-conductrice selon l'une des revendications 1 à 7, **caractérisée en ce que** le substrat (1) présente un niveau de dopage du premier type de conductivité adapté pour former un contact ohmique avec l'électrode de drain (D).

9. Structure semi-conductrice selon l'une des revendications 1 à 8, **caractérisée en ce que** la deuxième région semi-conductrice (3) présente un niveau de dopage du second type de conductivité adapté pour former un contact ohmique avec la première électrode de grille (G1).

10. Structure semi-conductrice selon l'une des revendications 1 à 9, **caractérisée en ce qu'**elle comporte au moins une couche de protection (6) du second type de conductivité agencée en périphérie d'une jonction entre la première et la seconde région semi-conductrice (2, 3), la couche de protection (6) présentant un niveau de dopage adapté pour optimiser la tenue en tension de la structure semi-conductrice.

11. Structure semi-conductrice selon l'une des revendications 1 à 10, **caractérisée en ce que** le substrat (1), la première et la deuxième région semi-conductrice (2, 3) sont réalisés dans un matériau sélectionné dans le groupe comportant le carbure de silicium, le nitrure de gallium et le diamant, et de préférence le carbure de silicium.

12. Interrupteur électronique de puissance, **caractérisé en ce qu'**il comporte une pluralité de structures semi-conductrices (SC) selon l'une des revendications 1 à 11.

13. Interrupteur électronique de puissance selon la revendication 12, **caractérisé en ce que** la pluralité de structures semi-conductrices (SC) est agencée de manière à délimiter au moins un premier motif (M) hexagonal sensiblement régulier et/ou au moins un deuxième motif en bandes interdigitées (BI).

14. Interrupteur électronique de puissance selon la revendication 13, **caractérisé en ce qu'**il comporte une cellule de protection (P) de la première électrode de grille (G1) agencée sensiblement au centre de chaque premier motif (M) et/ou agencée entre deux bandes interdigitées (BI) de chaque deuxième motif.

## Patentansprüche

1. Halbleiterstruktur für elektronischen Leistungsschalter, die Folgendes umfasst:
- ein Substrat (1) mit einem ersten Leitfähigkeitstyp, das eine untere Seite (10) und eine obere Seite (11) umfasst,
- eine Drain-Elektrode (D), die mit der unteren Seite (10) des Substrats (1) in Kontakt ist,
- eine erste Halbleiterregion (2) mit dem ersten Leitfähigkeitstyp, die eine untere Fläche (20), die auf der oberen Seite (11) des Substrats (1) angeordnet ist, und eine obere Fläche (21) aufweist, die mit einer Kontaktzone (210) versehen ist,
- eine Source-Elektrode (S), die mit der Kontaktzone (210) der ersten Halbleiterregion (2) in Kontakt ist,
- eine zweite Halbleiterregion (3) mit einem zweiten Leitfähigkeitstyp, die im Inneren der ersten Halbleiterregion (2) unter der Kontaktzone (210) angeordnet ist, derart dass ein erster und ein zweiter Leitungskanal (C1, C2) mit dem ersten Leitfähigkeitstyp zwischen der Drain-Elektrode (D) und der Source-Elektrode (S) abgegrenzt wird, wobei der zweite Leitungskanal (C2) sich entlang einer zweiten Richtung im Wesentlichen vertikal erstreckt und der erste Leitungskanal (C1) sich entlang einer ersten Richtung im Wesentlichen senkrecht zu der zweiten Richtung erstreckt,
wobei die Halbleiterstruktur ferner Folgendes umfasst:
- eine erste metallische Gate-Elektrode (G1), die unabhängig von der Source-Elektrode ist und mindestens einen ersten Abschnitt (70), der mit der zweiten Halbleiterregion (3) in Kontakt ist, und mindestens einen zweiten Abschnitt (71) umfasst, der mit der ersten Halbleiterregion (2) in Kontakt ist, derart dass ein erster Übergang vom Schottky-Typ gebildet wird, wobei der erste Übergang von der zweiten Halbleiterregion umgeben ist, und
- eine zweite metallische Gate-Elektrode (G2), die unabhängig von der Source-Elektrode ist und mindestens einen ersten Abschnitt (40) aufweist, der derart mit der oberen Fläche (21) der ersten Halbleiterregion (2) in Kontakt ist, dass ein zweiter Übergang vom Schottky-Typ gebildet wird, wobei die zweite Gate-Elektrode (G2) mit Abstand von der Kontaktzone (210) angeordnet ist.

2. Halbleiterstruktur nach Anspruch 1, **dadurch gekennzeichnet, dass** die zweite Halbleiterregion (3) mindestens ein Gehäuse (30) mit dem zweiten Leitfähigkeitstyp umfasst, das derart unter dem zweiten Abschnitt (71) der ersten Gate-Elektrode (G1) angeordnet ist, dass ein erster Übergang vom Schottky-Typ auf beiden Seiten des oder jedes Gehäuses (30) abgegrenzt wird.

3. Halbleiterstruktur nach Anspruch 2, **dadurch gekennzeichnet, dass** jedes Gehäuse (30) ein Dotierungsniveau vom zweiten Leitfähigkeitstyp aufweist, das geeignet ist, einen ohmschen Kontakt mit der ersten Gate-Elektrode (G1) zu bilden.

4. Halbleiterstruktur nach einem der Ansprüche 1 bis 3, **dadurch gekennzeichnet, dass** die obere Seite (21) der ersten Halbleiterregion (2) mindestens ein Gehäuse mit dem zweiten Leitfähigkeitstyp umfasst, das derart unter dem ersten Abschnitt (40) der zweiten Gate-Elektrode (G2) angeordnet ist, dass ein zweiter Übergang vom Schottky-Typ auf beiden Seiten des oder jedes Gehäuses abgegrenzt wird.

5. Halbleiterstruktur nach Anspruch 4, **dadurch gekennzeichnet, dass** jedes Gehäuse ein Dotierungsniveau vom zweiten Leitfähigkeitstyp aufweist, das geeignet ist, einen ohmschen Kontakt mit der zweiten Gate-Elektrode (G2) zu bilden.

6. Halbleiterstruktur nach einem der Ansprüche 1 bis 5, **dadurch gekennzeichnet, dass** sie eine dielektrische Schicht (5) umfasst, die vorzugsweise aus Silizium ausgeführt ist, die auf der oberen Seite (21) der ersten Halbleiterregion (2) angeordnet ist, und dadurch, dass die zweite Gate-Elektrode (G2) mindestens einen zweiten Abschnitt (41) aufweist, der die dielektrische Schicht (5) überragt.

7. Halbleiterstruktur nach einem der Ansprüche 1 bis 6, **dadurch gekennzeichnet, dass** die Kontaktzone (210) ein Dotierungsniveau vom ersten Leitfähigkeitstyp aufweist, das geeignet ist, einen ohmschen Kontakt mit der Source-Elektrode (S) zu bilden.

8. Halbleiterstruktur nach einem der Ansprüche 1 bis 7, **dadurch gekennzeichnet, dass** das Substrat (1) ein Dotierungsniveau vom ersten Leitfähigkeitstyp aufweist, das geeignet ist, einen ohmschen Kontakt mit der Drain-Elektrode (D) zu bilden.

9. Halbleiterstruktur nach einem der Ansprüche 1 bis 8, **dadurch gekennzeichnet, dass** die zweite Halbleiterregion (3) ein Dotierungsniveau vom zweiten Leitfähigkeitstyp aufweist, das geeignet ist, einen ohmschen Kontakt mit der ersten Gate-Elektrode (G1) zu bilden.

10. Halbleiterstruktur nach einem der Ansprüche 1 bis 9, **dadurch gekennzeichnet, dass** sie mindestens eine Schutzschicht (6) mit dem zweiten Leitfähigkeitstyp umfasst, die am Umfang zwischen der ersten und der zweiten Halbleiterregion (2, 3) angeordnet ist, wobei die Schutzschicht (6) ein Dotierungsniveau aufweist, das geeignet ist, um die Spannungsfestigkeit der Halbleiterstruktur zu optimieren.

11. Halbleiterstruktur nach einem der Ansprüche 1 bis 10, **dadurch gekennzeichnet, dass** das Substrat (1), die erste und die zweite Halbleiterregion (2, 3) aus einem Material, das aus der Gruppe ausgewählt ist, die Siliziumkarbid, Galliumnitrid und Diamant umfasst, und vorzugsweise Siliziumkarbid ausgeführt sind.

12. Elektronischer Leistungsschalter, **dadurch gekennzeichnet, dass** er mehrere Halbleiterstrukturen (SC) nach einem der Ansprüche 1 bis 11 umfasst.

13. Elektronischer Leistungsschalter nach Anspruch 12, **dadurch gekennzeichnet, dass** die mehreren Halbleiterstrukturen (SC) derart angeordnet sind, dass sie mindestens eine erste, im Wesentlichen gleichmäßige sechseckige Struktur (M) und/oder mindestens eine zweite Struktur aus Interdigitalbändern (BI) abgrenzen.

14. Elektronischer Leistungsschalter nach Anspruch 13, **dadurch gekennzeichnet, dass** er eine Schutzzelle (P) der ersten Gate-Elektrode (G1) umfasst, die im Wesentlichen in der Mitte von jeder ersten Struktur (M) angeordnet ist und/oder zwischen zwei Interdigitalbändern (BI) von jeder zweiten Struktur angeordnet ist.

## Claims

1. A semiconductor structure for an electronic power switch, including:
- a substrate (1) of a first type of conductivity, having a lower face (10) and an upper face (11),
- a drain electrode (D) in contact with the lower face (10) of the substrate (1),
- a first semiconductor region (2) of the first type of conductivity, having a lower surface (20) arranged on the upper face (11) of the substrate (1), and an upper surface (21) provided with a contact area (210),
- a source electrode (S) in contact with the contact area (210) of the first semiconductor region (2),
- a second semiconductor region (3), of a second type of conductivity, arranged inside the first semiconductor region (2), under the contact area (210), so as to delimit a first and a second conduction channels (C1, C2) of the first type of conductivity between the drain electrode (D) and the source electrode (S), the second conduction channel (C2) extending in a second substantially vertical direction and the first conduction channel (C1) extending in a first direction substantially perpendicular to the second direction,
the semiconductor structure further including:
- a first metal gate electrode (G1) independent of the source electrode and having at least a first portion (70) in contact with the second semiconductor region (3), and at least a second portion (71) in contact with the first semiconductor region (2) so as to form a first Schottky-type junction, the first junction being surrounded by the second semiconductor region, and
- a second metal gate electrode (G2) independent of the source electrode and having at least a first portion (40) in contact with the upper surface (21) of the first semiconductor region (2) so as to form a second Schottky-type junction, the second gate electrode (G2) being arranged at a distance from the contact area (210).

2. The semiconductor structure according to claim 1, **characterized in that** the second semiconductor region (3) includes at least one casing (30), of the second type of conductivity, arranged under the second portion (71) of the first gate electrode (G1) so as to delimit a first Schottky-type junction on either side of the or each casing (30).

3. The semiconductor structure according to claim 2, **characterized in that** each casing (30) has a doping level of the second type of conductivity adapted to form an ohmic contact with the first gate electrode (G1).

4. The semiconductor structure according to any of claims 1 to 3, **characterized in that** the upper face (21) of the first semiconductor region (2) includes at least one casing, of the second type of conductivity, arranged under the first portion (40) of the second gate electrode (G2) so as to delimit a second Schottky-type junction of on either side of the or each casing.

5. The semiconductor structure according to claim 4, **characterized in that** each casing has a doping level of the second type of conductivity adapted to form an ohmic contact with the second gate electrode (G2).

6. The semiconductor structure according to any of claims 1 to 5, **characterized in that** it includes a dielectric layer (5), preferably made of silica, arranged on the upper face (21) of the first semiconductor region (2), and **in that** the second gate electrode (G2) has at least a second portion (41) on top of the dielectric layer (5).

7. The semiconductor structure according to any of claims 1 to 6, **characterized in that** the contact area (210) has a doping level of the first type of conductivity adapted to form an ohmic contact with the source electrode (S).

8. The semiconductor structure according to any of claims 1 to 7, **characterized in that** the substrate (1) has a doping level of the first type of conductivity adapted to form an ohmic contact with the drain electrode (D).

9. The semiconductor structure according to any of claims 1 to 8, **characterized in that** the second semiconductor region (3) has a doping level of second type of conductivity adapted to form an ohmic contact with the first gate electrode (G1).

10. The semiconductor structure according to any of claims 1 to 9, **characterized in that** it includes at least one protection layer (6) of the second type of conductivity arranged on the periphery of a junction between the first and the second semiconductor regions (2, 3), the protection layer (6) having a doping level adapted to optimize the voltage withstand of the semiconductor structure.

11. The semiconductor structure according to any of claims 1 to 10, **characterized in that** the substrate (1) and the first and second semiconductor regions (2, 3) are made of a material selected from the group including silicon carbide, gallium nitride and diamond, and preferably silicon carbide.

12. An electronic power switch **characterized in that** it includes a plurality of semiconductor structures (SC) according to any of claims 1 to 11.

13. The electronic power switch according to claim 12, **characterized in that** the plurality of semiconductor structures (SC) is arranged so as to delimit at least a first substantially regular hexagonal pattern (M) and/or at least a second interdigitated band (BI) pattern.

14. The electronic power switch according to claim 13, **characterized in that** it includes a protection cell (P) of the first gate electrode (G1) arranged substantially in the center of each first pattern (M) and/or arranged between two interdigitated bands (BI) of each second pattern.
